# FASCICULE DE BREVET EUROPEEN

(11) **EP 4 578 047 B1**
(45) Date de publication et mention de la délivrance du brevet: **19.11.2025**
(21) Numéro de dépôt: 24703603.1
(22) Date de dépôt: 12.01.2024
(51) Int. Cl.: H10F 39/00, H10F 39/18

(54) **CIRCUIT DE LECTURE POUR CAPTEUR HYBRIDE**
AUSLESESCHALTUNG FÜR EINEN HYBRIDSENSOR
READOUT CIRCUIT FOR A HYBRID SENSOR

(30) Priorité: 24.05.2023 FR 2305120
(43) Date de publication de la demande: 02.07.2025
(73) Titulaire: Airbus Defence and Space SAS, 31402 Toulouse Cedex 4 (FR)
(72) Inventeur: SAINT-PE, Olivier, 31520 RAMONVILLE (FR); BREART DE BOISANGER, Michel Yves Marie, 31400 TOULOUSE (FR); MARCHAIS, Denis, 31402 TOULOUSE CEDEX 4 (FR); RIZZOLO, Serena, 31402 TOULOUSE CEDEX 4 (FR)
(74) Mandataire: Plasseraud IP
(86) Numéro de dépôt international: PCT/FR2024/050046
(87) Numéro de publication internationale: WO 2024/240996

(56) Documents cités:
- EP-A1- 0 571 268
- EP-A1- 0 654 825
- EP-A1- 3 913 577
- US-A1- 2006 181 627

## Description

### Domaine technique

La présente description concerne un circuit de lecture pour capteur hybride, le capteur hybride et un procédé d'intégration de ce dernier dans un instrument optique.

### Technique antérieure

Les capteurs optiques quantiques qui sont efficaces dans le domaine spectral infrarouge sont généralement réalisés sous forme de capteurs hybrides, c'est-à-dire qu'ils sont réalisés en associant deux substrats semiconducteurs différents : un substrat semiconducteur à faible largeur de bande interdite («gap» en anglais) pour constituer un circuit de détection infrarouge, et un substrat de silicium pour constituer un circuit de lecture («readout circuit» en anglais). Le substrat semiconducteur à faible largeur de bande interdite est couramment en tellure de cadmium et de mercure (HgCdTe), en antimoniure d'indium (InSb), ou bien comprend une structure à puits quantiques telle qu'un super-réseau de type II («Type II Super-Lattice» en anglais). Chaque circuit de détection infrarouge comprend au moins un photodétecteur qui est sensible dans le domaine spectral infrarouge, et le circuit de lecture comprend généralement autant de cellules de lecture qu'il y a de photodétecteurs dans le circuit de détection infrarouge. Les deux circuits - le circuit de détection infrarouge et son circuit de lecture - sont assemblés rigidement l'un à l'autre par des connexions électriques qui relient généralement chacune un photodétecteur du circuit de détection infrarouge à une cellule de lecture du circuit de lecture. Plusieurs méthodes d'assemblage sont utilisées alternativement pour cela, notamment l'assemblage par billes d'indium, la méthode dite cuivre-cuivre ou la méthode de vias traversants dans le silicium qui est désignée par TSV pour «Through-Silicon Via» en anglais.

De tels capteurs hybrides peuvent notamment constituer des capteurs d'images matriciels. Dans ce cas, les photodétecteurs dans le circuit de détection infrarouge et les cellules de lecture dans le circuit de lecture sont disposés selon des agencements matriciels qui coïncident pour l'assemblage.

Ces capteurs hybrides qui sont efficaces dans le domaine spectral infrarouge doivent généralement être refroidis pour être utilisés. Pour cela, chaque capteur hybride est intégré dans un sous-ensemble qui est couramment désigné par IDDCA, pour «Integrated Detector-Dewar-Cooler Assembly» en anglais, et qui regroupe le capteur hybride lui-même, un hublot transparent dans le domaine spectral infrarouge, un cryostat destiné à empêcher une formation de glace sur les éléments refroidis et intégrant un plan de pose du capteur hybride, un écran froid monté sur le plan de pose pour limiter un angle de vue du capteur hybride à celui d'un système optique utilisé en amont, une machine à froid et des connexions électriques qui relient le capteur hybride à l'extérieur de l'IDDCA. Usuellement, la position du capteur hybride au sein de l'IDDCA peut être ajustée mécaniquement à quelques dizaines de micromètres près, typiquement, puis la position de l'IDDCA au sein d'un instrument optique est ajustée en refroidissant le capteur hybride et en utilisant son fonctionnement de détection optique. L'intégration du capteur hybride dans l'IDDCA est usuellement effectuée par le fabricant de cet IDDCA. Ensuite, l'IDDCA est utilisé pour refroidir le capteur hybride, typiquement jusqu'à une température qui est comprise entre 50 K (Kelvin) et 200 K, afin de régler la position de l'IDDCA au sein de l'instrument optique.

Toutefois, il existe des applications pour lesquelles un IDDCA commercial ne peut pas être utilisé, notamment dans les situations suivantes :
- lorsque le capteur hybride est d'un modèle conçu à la demande pour une application spécifique, et n'est compatible avec aucun modèle commercial d'IDDCA ;
- lorsque d'autres éléments optiques, par exemple d'autres capteurs optiques, doivent être intégrés très près du capteur hybride ;
- lorsque les modèles commerciaux d'IDDCA ne sont pas compatibles avec des températures d'utilisation qui sont trop basses ;
- lorsque les IDDCA commerciaux ne sont pas qualifiés pour les conditions d'utilisation ou d'environnement de l'application envisagée ; et
- lorsque les modèles d'IDDCA commerciaux ne permettent pas de re-démonter ou de réparer un plan focal d'instrument optique dans lequel le capteur hybride est intégré. Tel est le cas la plupart des fois pour un capteur hybride qui est destiné à être utilisé à bord d'un engin spatial, notamment à bord d'un satellite. En effet, le nombre très réduit d'unités de capteurs hybrides d'un même modèle qui sont produits pour des applications spatiales n'est pas compatible avec une mise à disposition commerciale d'IDDCA qui soient adaptés pour chaque modèle. Amener le capteur hybride à basse température et sous vide afin d'utiliser ses photodétecteurs infrarouges pour réaliser l'ajustement de position nécessite alors un temps d'opérateur et des ressources matérielles considérables. Ceci est particulièrement le cas lorsque le capteur hybride fait partie d'un assemblage de plan focal qui est complexe. Il serait alors avantageux, notamment pour de telles applications spatiales, de disposer de capteurs hybrides qui puissent être ajustés en position facilement et rapidement dans un instrument d'optique. Par exemple les deux documents suivants décrivent des exemples de capteurs selon l'état de l'art.

Le document EP 3 913 577 A1, concerne un capteur monolithique. Ce dernier n'est pas un capteur hybride à deux substrats séparés. Et, le document EP 0 571 268 A1, concerne un système de conversion d'image infrarouge à visible, qui est dépourvu de photodétecteurs intégrés à un substrat de silicium et distincts des photodétecteurs infrarouges.

### Problème technique

A partir de cette situation, un but de la présente invention est de fournir de nouveaux capteurs hybrides qui puissent être intégrés facilement et rapidement dans des instruments optiques. Plus particulièrement, l'invention a pour but de proposer de nouveaux capteurs hybrides qui puissent être ajustés en position facilement et rapidement dans les instruments optiques.

Notamment, un but de l'invention est de permettre qu'un capteur hybride puisse être ajusté en position dans un instrument optique, au moins partiellement, sans nécessiter de refroidir ce capteur hybride à basse température et/ou de le mettre dans des conditions de basse pression.

Un but supplémentaire de l'invention est de fournir un capteur hybride qui puisse être ajusté en position dans un instrument optique avec une précision suffisante, latéralement et/ou transversalement par rapport à un axe optique de l'instrument optique.

En particulier, l'invention a pour but de faciliter l'intégration d'un capteur hybride dans un instrument optique qui est destiné à être utilisé dans l'espace, notamment lorsque ce capteur hybride n'est pas compatible avec un modèle commercial d'IDDCA.

Enfin, un but annexe de l'invention est de permettre de tester électriquement une chaîne de traitement des signaux de détection qui sont délivrés par le capteur hybride, d'une façon simplifiée, rapide et économique, et éventuellement aussi de mesurer au moins partiellement les caractéristiques de compatibilité électromagnétique de cette chaîne de traitement des signaux de détection.

### Résumé de l'invention

Pour atteindre l'un au moins de ces buts ou un autre, un premier aspect de l'invention propose un nouveau circuit de lecture intégré à substrat de silicium, qui est adapté pour être connecté à un circuit intégré de photodétecteurs sensibles dans un domaine spectral infrarouge, ce dernier étant externe au circuit de lecture et appelé circuit de détection infrarouge, afin de former un capteur hybride. Le circuit de lecture comprend :
- des cellules de lecture qui sont séparées les unes des autres à l'intérieur de ce circuit de lecture ; et
- des zones de contacts électriques qui sont dédiées respectivement à certaines au moins des cellules de lecture, et adaptées pour transférer à celles-ci, dans un premier mode de fonctionnement du circuit de lecture pour lequel il est connecté au circuit de détection infrarouge, des charges photoélectriques qui ont été générées dans les photodétecteurs du circuit de détection infrarouge.

Selon l'invention, le circuit de lecture comprend en outre :
- des photodétecteurs supplémentaires qui sont intégrés à ce circuit de lecture, et qui sont distincts des photodétecteurs du circuit de détection infrarouge.

En outre, le circuit de lecture de l'invention est agencé pour, dans un second mode de fonctionnement de ce circuit de lecture, transférer à certaines des cellules de lecture, d'une façon interne au circuit de lecture, d'autres charges photoélectriques qui ont été générées dans les photodétecteurs supplémentaires.

Le premier mode de fonctionnement du circuit de lecture de l'invention est ainsi dédié à une mission de détection dans le domaine spectral infrarouge, pour laquelle ce circuit de lecture est utilisé. Pour cette raison, ce premier mode de fonctionnement met en œuvre des cellules de lecture qui reçoivent des signaux de détection produits par les photodétecteurs du circuit de détection infrarouge. Pour cela, ce circuit de détection infrarouge peut être constitué à partir d'un substrat semiconducteur à faible largeur de bande interdite, typiquement inférieure à 1,0 eV (électron-volt, 1 eV = 1,6·10⁻¹⁹ joules).

Le second mode de fonctionnement du circuit de lecture de l'invention utilise des photodétecteurs, appelés photodétecteurs supplémentaires, qui appartiennent à ce circuit de lecture, avec les cellules de lecture auxquelles sont transmis les signaux de détection produits par ces photodétecteurs supplémentaires. Ainsi, le second mode de fonctionnement du circuit de lecture de l'invention peut être indépendant du circuit de détection infrarouge. Il ne nécessite donc pas nécessairement que soient mises en œuvre les conditions de basse température et/ou de basse pression qui peuvent être indispensables pour le premier mode de fonctionnement. Ce second mode de fonctionnement peut alors être particulièrement avantageux pour réaliser l'intégration du capteur hybride dans un instrument optique, en permettant de réaliser une partie au moins de cette intégration sans mettre en œuvre les conditions de basse température et/ou de basse pression qui sont indispensables pour le premier mode de fonctionnement. II en résulte une réduction importante du temps opératoire et des moyens matériels qui sont nécessaires à l'intégration du capteur hybride dans l'instrument optique, et par conséquent une réduction significative du prix de revient de cette intégration.

Le surcoût pour le circuit de lecture que provoque l'ajout des photodétecteurs supplémentaires peut être limité, lorsque ces photodétecteurs supplémentaires sont réalisés en utilisant des procédés standards de fabrication des circuits intégrés.

De préférence, le circuit de lecture peut comprendre un premier ensemble de cellules de lecture qui sont dédiées au premier mode de fonctionnement, et un second ensemble de cellules de lecture qui sont dédiées au second mode de fonctionnement, les premier et second ensembles de cellules de lecture étant séparés. Autrement dit, le circuit de lecture de l'invention peut être agencé de sorte qu'une partie de ses cellules de lecture soient connectées électriquement aux zones de contacts électriques sans être connectées électriquement à des sorties des photodétecteurs supplémentaires, et qu'une partie supplémentaire de ses cellules de lecture soient connectées électriquement aux sorties des photodétecteurs supplémentaires sans être connectées électriquement aux zones de contacts électriques. De cette façon, la première partie des cellules de lecture du circuit de lecture ne peut recevoir des charges photoélectriques qu'à travers les zones de contacts électriques, à l'exclusion d'autres charges photoélectriques qui sont générées dans les photodétecteurs supplémentaires, et la partie supplémentaire des cellules de lecture ne peut recevoir que les autres charges photoélectriques qui sont générées dans les photodétecteurs supplémentaires, à l'exclusion des charges photoélectriques provenant des zones de contacts électriques.

En particulier, les cellules de lecture du premier ensemble, qui sont dédiées au premier fonctionnement, peuvent être positionnées par rapport aux photodétecteurs supplémentaires qui sont utilisés pour le second fonctionnement, avec une précision élevée, notamment une précision plus fine que 1 µm (micromètre), en tous cas supérieure au besoin d'alignement optique, lorsque ce premier ensemble de cellules de lecture et ces photodétecteurs supplémentaires sont réalisés en même temps lors d'étapes communes de photolithographie.

De préférence aussi, le circuit de lecture peut être adapté en outre pour empêcher que des charges photoélectriques soient générées dans les photodétecteurs du circuit de détection infrarouge, ou pour empêcher que des charges photoélectriques qui sont générées dans les photodétecteurs du circuit de détection infrarouge soient transférées à des cellules de lecture de ce circuit de lecture, dans le second mode de fonctionnement et si le circuit de lecture est connecté au circuit de détection infrarouge. Ainsi, un risque de dégradation des photodétecteurs du circuit de détection infrarouge dans le second mode de fonctionnement du circuit de lecture est évité. Une telle précaution peut être utile lorsque le circuit de détection infrarouge doit être à basse température et/ou basse pression pour fonctionner sans risque d'endommagement, et lorsque que le second mode de fonctionnement est possible à température et/ou pression ambiante(s).

L'invention est particulièrement avantageuse lorsque les photodétecteurs supplémentaires du circuit de lecture sont de technologie CMOS à base de silicium. Le second mode de fonctionnement peut alors être utilisé à température et/ou pression ambiante(s), si bien que ce second mode de fonctionnement peut permettre de réaliser au moins en partie l'intégration du capteur hybride dans l'instrument optique à faible coût.

Dans des modes préférés de réalisation de l'invention, l'une au moins des caractéristiques additionnelles suivantes peut être reproduite optionnellement, seule ou en combinaison de plusieurs d'entre elles :
- chaque photodétecteur supplémentaire du circuit de lecture peut être une photodiode qui est réalisée dans ou sur le substrat de silicium du circuit de lecture, une capacité Metal-Oxyde-Silicium ou Polysilicium-Oxyde-Silicium qui est réalisée sur le substrat de silicium du circuit de lecture, ou un phototransistor qui est réalisé dans ou sur le substrat de silicium du circuit de lecture ;
- chaque photodétecteur supplémentaire du circuit de lecture peut être sensible dans un intervalle spectral qui est compris entre 0,4 µm et 1,1 µm. Tel est le cas, notamment, lorsque les photodétecteurs supplémentaires du circuit de lecture sont de technologie CMOS à base de silicium ;
- les photodétecteurs supplémentaires du circuit de lecture peuvent être situés sur un même côté du circuit de lecture que les zones de contacts électriques qui sont destinées à connecter le circuit de détection infrarouge au circuit de lecture. Ces photodétecteurs supplémentaires sont ainsi situés de façon appropriée pour ajuster optiquement une position du capteur hybride pendant son intégration dans l'instrument optique ;
- les photodétecteurs supplémentaires du circuit de lecture peuvent être répartis sur une face de ce circuit de lecture selon au moins une disposition matricielle, en étant situés à des intersections de colonnes et de lignes de cette disposition matricielle. Ainsi, les photodétecteurs supplémentaires avec leurs cellules de lecture associées constituent un capteur d'images annexe, qui est indépendant du circuit de détection infrarouge. Ce capteur d'images annexe peut permettre d'ajuster la position du circuit intégré de photodétecteurs avec une précision qui est supérieure, voire très supérieure, au besoin d'alignement optique ; et
- les zones de contacts électriques du circuit de lecture peuvent être réparties selon une autre disposition matricielle, en étant situés à des intersections de colonnes et de lignes de cette autre disposition matricielle. Autrement dit, le capteur hybride peut constituer un capteur d'images infrarouges dans le premier mode de fonctionnement du circuit de lecture. Possiblement, un pas («pitch» en anglais) de la disposition matricielle des photodétecteurs supplémentaires peut être différent d'un pas de l'autre disposition matricielle des zones de contacts électriques. Notamment, le pas de la disposition matricielle des photodétecteurs supplémentaires peut être plus petit que le pas de l'autre disposition matricielle des zones de contacts électriques. Ainsi, le capteur d'images annexe qui est constitué par les photodétecteurs supplémentaires procure une précision d'ajustement de la position du capteur hybride dans l'instrument optique, qui est suffisante pour l'utilisation ultérieure du capteur hybride selon le premier mode de fonctionnement.

Un deuxième aspect de l'invention propose un capteur hybride qui comprend :
- un circuit de lecture qui est conforme au premier aspect de l'invention ci-dessus, possiblement avec ses perfectionnements facultatifs ;
- le circuit de détection infrarouge, qui comprend les photodétecteurs sensibles dans le domaine spectral infrarouge, et qui est connecté au circuit de lecture ; et
- des éléments de connexions électriques qui relient une-à-une les zones de contacts électriques du circuit de lecture à des zones de contacts électriques du circuit de détection infrarouge, de façon à transférer pendant une utilisation du circuit hybride conforme au premier mode de fonctionnement du circuit de lecture, les charges photoélectriques générées dans les photodétecteurs du circuit de détection infrarouge aux cellules de lecture correspondantes du circuit de lecture.

Enfin, un troisième aspect de l'invention concerne un procédé d'intégration d'un capteur hybride dans un instrument optique qui comprend un système imageur, le système imageur étant destiné à former une image sur le circuit de détection infrarouge du capteur hybride pendant une utilisation de l'instrument optique, le procédé étant caractérisé en ce que :
- le capteur hybride est conforme au deuxième aspect de l'invention, et les photodétecteurs supplémentaires de son circuit de lecture sont répartis sur une face de celui-ci selon au moins une disposition matricielle, en étant situés à des intersections de colonnes et de lignes de cette disposition matricielle ; et
- le procédé comprend au moins une étape d'alignement optique lors de laquelle une position du circuit de lecture par rapport au système imageur est mesurée ou ajustée en utilisant les photodétecteurs supplémentaires du circuit de lecture.

Ainsi, les photodétecteurs supplémentaires du circuit de lecture sont utilisés pour mesurer ou ajuster la position de ce circuit de lecture par rapport au système imageur, pendant l'intégration du capteur hybride dans l'instrument optique. Cette étape d'intégration en position peut être effectuée avec ou sans le circuit de détection infrarouge assemblé sur le circuit de lecture. De plus, si le circuit de lecture le permet, notamment lorsqu'il est de technologie CMOS à base de silicium, l'intégration en position du circuit de lecture dans l'instrument optique peut être réalisée à température et pression ambiantes, au lieu de la réaliser à basse température et/ou à basse pression.

Il peut s'agir d'un alignement transversal du circuit de lecture dans l'instrument optique. Dans ce cas, l'étape d'alignement optique comprend d'ajuster la position du circuit de lecture perpendiculairement à l'axe optique du système imageur, en utilisant une mire qui est positionnée fixement par rapport au système imageur de sorte que le système imageur forme une image de la mire sur les photodétecteurs supplémentaires du circuit de lecture. Le second mode de fonctionnement du circuit de lecture est alors activé pour saisir l'image qui est formée sur les photodétecteurs supplémentaires, et la position du circuit de lecture est ajustée perpendiculairement à l'axe optique du système imageur pour réduire un décalage entre l'image saisie et les photodétecteurs supplémentaires.

Il peut aussi s'agir d'un alignement longitudinal du circuit de lecture dans l'instrument optique. Dans cet autre cas, l'étape d'alignement optique comprend d'ajuster la position du circuit de lecture le long de l'axe optique du système imageur, en utilisant un motif de contraste qui est positionné fixement par rapport au système imageur de sorte que le système imageur forme une image du motif de contraste sur les photodétecteurs supplémentaires du circuit de lecture. Le second mode de fonctionnement du circuit de lecture est alors activé pour saisir l'image qui est formée sur les photodétecteurs supplémentaires, et la position du circuit de lecture est ajustée le long de l'axe optique du système imageur pour maximiser un contraste de l'image saisie.

Pour de tels alignements optiques transversal et longitudinal, la mire ou le motif de contraste, respectivement, peut être combiné(e) rigidement avec un collimateur de sorte que la mire ou le motif de contraste soit situé(e) dans un plan focal objet du collimateur. Le système imageur de l'instrument optique forme alors l'image qui est saisie par les photodétecteurs supplémentaires à partir de rayons lumineux transmis par le collimateur.

Par ailleurs, le procédé d'intégration de l'invention peut comprendre en outre une étape de test électrique ou électromagnétique, lors de laquelle un fonctionnement d'une chaîne de traitement de signaux électriques qui est connectée en aval du circuit de lecture, est testée en mettant en œuvre le second mode de fonctionnement du circuit de lecture. Cette étape peut constituer une partie ou la totalité du test électrique ou électromagnétique.

### Brève description des figures

Les caractéristiques et avantages de la présente invention apparaîtront plus clairement dans la description détaillée ci-après d'exemples de réalisation non-limitatifs, en référence aux figures annexées parmi lesquelles :
[Fig. 1a] est une vue en section transversale d'un capteur hybride qui est conforme à l'invention ;
[Fig. 1b] est une vue en plan du capteur hybride de [Fig. 1a] ;
[Fig. 2a] est un schéma électrique simplifié d'un modèle de cellule de lecture qui peut être utilisé dans le capteur hybride de [Fig. 1a] et [Fig. 1b] pour des photodétecteurs sensibles dans le domaine spectral infrarouge ;
[Fig. 2b] correspond à [Fig. 2a] pour des photodétecteurs supplémentaires ajoutés par l'invention ;
[Fig. 3a] illustre une étape d'alignement optique du capteur hybride de [Fig. 1a] et [Fig. 1b] dans un instrument optique ; et
[Fig. 3b] correspond à [Fig. 3a] en utilisant une variante d'agencement optique.

### Description détaillée de l'invention

Pour raison de clarté, les dimensions des éléments qui sont représentés dans ces figures ne correspondent ni à des dimensions réelles, ni à des rapports de dimensions réels. En outre, certains de ces éléments ne sont représentés que symboliquement, et des références identiques qui sont indiquées dans des figures différentes désignent des éléments identiques ou qui ont des fonctions identiques. Enfin, des éléments, composants et connexions électriques, telles que des connexions électriques d'alimentation ou de polarisation, ne sont pas représentées dans ces figures si elles ne sont pas directement liées à l'invention décrite.

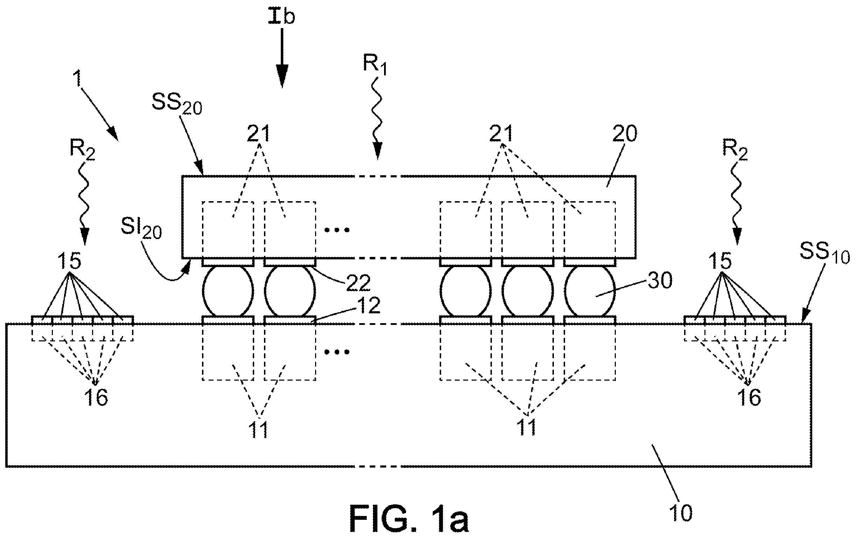

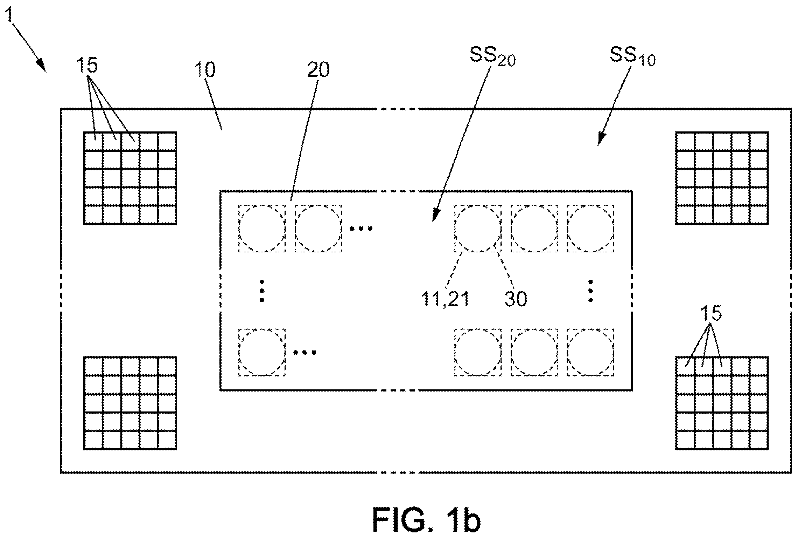

Conformément à [Fig. 1a] et [Fig. 1b], un capteur d'images quantique hybride est constitué par l'assemblage d'un circuit de lecture 10 et d'un circuit de détection infrarouge 20.

Le circuit de détection infrarouge 20 peut être d'un modèle connu avant la présente invention, qui est produit à partir d'un substrat à faible largeur de bande interdite tel qu'un substrat de tellure de cadmium et de mercure (HgCdTe), à titre d'exemple. Il comporte un ensemble de photodétecteurs 21 qui sont identiques et disposés selon un agencement matriciel, et qui peuvent être sensibles spectralement entre 1 µm et 20 µm, en termes de valeur de longueur d'onde du rayonnement à détecter. Un pas de la matrice d'agencement des photodétecteurs 21 peut être égal à 15 µm environ, aussi à titre d'exemple. Le substrat du circuit de détection infrarouge 20 est contenu entre sa surface supérieure SS₂₀ et sa surface inférieure SI₂₀, qui sont parallèles et opposées l'une à l'autre. De façon connue, les photodétecteurs 21 du circuit 20 peuvent avoir été réalisés au niveau de la surface inférieure SI₂₀, puis le substrat du circuit 20 peut avoir été aminci à partir de sa surface supérieure SS₂₀. Un tel circuit de détection infrarouge 20 est alors destiné à détecter du rayonnement infrarouge R₁ qui est incident sur sa surface supérieure SS₂₀. Sur la surface inférieure SI₂₀ du circuit 20, chaque photodétecteur 21 est muni d'une zone de contact électrique 22 respective. Les zones de contacts électriques 22 sont toutes identiques et isolées électriquement entre elles. Chacune d'elle est destinée à transmettre à une cellule de lecture du circuit de lecture 10 des charges photoélectriques qui ont été générées dans le photodétecteur 21 correspondant par le rayonnement R₁.

Le circuit de lecture 10 peut être fabriqué à partir d'un substrat de silicium (Si) par la technologie CMOS. Il comporte des cellules de lecture 11 au niveau de sa surface supérieure SS₁₀, qui sont munies chacune d'une zone de contact électrique respective 12. Les zones de contacts électriques 12 sont toutes identiques et isolées électriquement entre elles. Les cellules de lecture 11 sont réparties dans la surface supérieure SS₁₀ du circuit de lecture 10 pour être chacune en vis-à-vis d'un seul photodétecteur 21 du circuit de détection infrarouge 20 lorsque les deux circuits 10 et 20 sont disposés avec leurs surfaces respectives SS₁₀ et SI₂₀ tournées l'une vers l'autre. Autrement dit, les cellules de lecture 11 sont réparties dans la surface supérieure SS₁₀ selon un agencement matriciel qui est l'image par un miroir de celui des photodétecteurs 21 dans la surface SI₂₀. Dans la pratique, l'agencement matriciel des photodétecteurs 21 étant à cellules carrées et à limite périphérique rectangulaire, celui des cellules de lecture 11 lui est identique.

Les deux circuits 10 et 20 sont assemblés rigidement par des éléments de connexion solides et conducteurs électriquement 30, pour former le capteur hybride 1. Chaque élément de connexion 30 relie une seule des zones de contacts électriques 22 du circuit de détection infrarouge 20 à une seule des zones de contacts électriques 12 du circuit de lecture 10. De cette façon, chacun des photodétecteurs 21 est connecté électriquement à une cellule de lecture 11, de sorte que des charges photoélectriques qui ont été générées dans un des photodétecteurs 21 par le rayonnement R₁ puissent être transférées à la cellule de lecture 11 correspondante. Ce fonctionnement de détection correspond à un premier mode de fonctionnement du circuit de lecture 10. Ce peut être notamment un mode de fonctionnement de saisie d'images. Les éléments de connexion 30 peuvent être des billes d'indium, mais d'autres techniques d'assemblage applicables aux circuits 10 et 20 sont très connues de l'Homme du métier.

[Fig. 1b] est une vue de dessus du circuit hybride 1, par rapport à [Fig. 1a].

Pour l'invention, le substrat du circuit de lecture 10 est plus grand que celui du circuit de détection infrarouge 20, de sorte que le circuit 10 possède au moins un débordement latéral par rapport au circuit 20. Dans [Fig. 1a] et [Fig. 1b], ces débordements sont situés notamment à droite et à gauche du circuit de détection infrarouge 20. Alors l'invention consiste à ajouter au circuit de lecture 10 au moins un ensemble de photodétection qui est indépendant des cellules de lecture 11 et des photodétecteurs 21. Chaque ensemble de photodétection qui est ainsi ajouté comprend au moins un photodétecteur 15, appelé photodétecteur supplémentaire, et au moins une cellule de lecture 16. Dans le circuit de lecture 10, chaque cellule de lecture 16 peut être située de préférence sous le photodétecteur supplémentaire 15 auquel elle est associée, et être connectée électriquement à lui de sorte que des charges photoélectriques qui sont générées dans ce photodétecteur supplémentaire 15 par un rayonnement R₂ qui est incident sur ce photodétecteur supplémentaire, soient transférées à la cellule de lecture 16 correspondante. Cet autre fonctionnement de détection correspond à un second mode de fonctionnement du circuit de lecture 10. Chaque photodétecteur supplémentaire 15 peut être d'un type déjà connu, tel qu'une photodiode, une capacité Metal-Oxyde-Silicium (MOS) ou Polysilicium-Oxyde-Silicium (POS), ou un phototransistor, réalisé(e) dans ou sur le substrat de silicium du circuit de lecture 10. Lorsque les photodétecteurs supplémentaires 15 de chaque ensemble de photodétection du circuit de lecture 10 sont répartis dans la surface SS₁₀ selon un agencement matriciel, le second mode de fonctionnement peut aussi être un mode de fonctionnement de saisie d'images. Mais le domaine spectral de sensibilité de ce second mode de fonctionnement est déterminé par la nature du matériau constitutif des photodétecteurs supplémentaires 15 : le domaine visible de rayonnement si ce matériau est à base de silicium, c'est-à-dire que les photodétecteurs supplémentaires 15 sont sensibles pour des valeurs de longueur d'onde du rayonnement R₂ qui sont comprises entre 0,4 µm et 1,1 µm. Dans l'exemple représenté, le circuit de lecture 10 comprend quatre agencements matriciels de photodétecteurs supplémentaires 15 avec les cellules de lecture 16 correspondantes. Le pas des photodétecteurs supplémentaires 15 dans chacun de ces agencements matriciels peut être égal à 5 µm, à titre d'exemple.

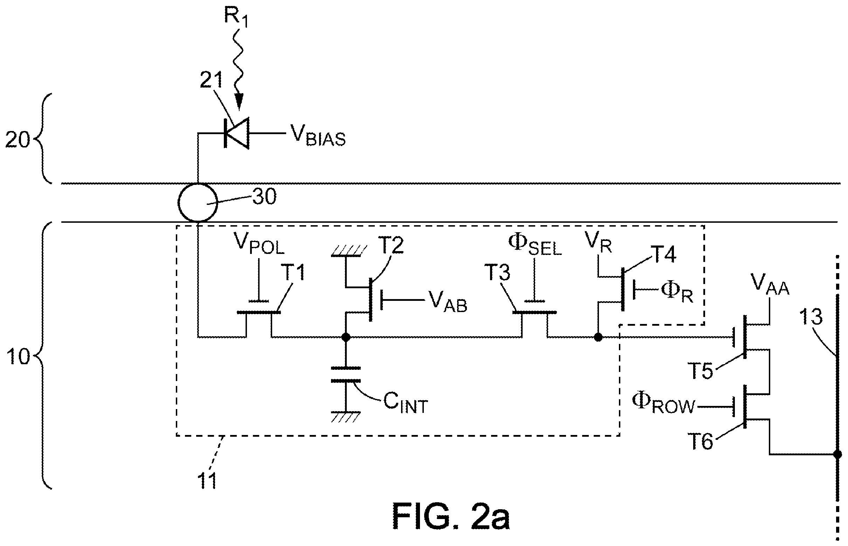

Les cellules de lecture 11 peuvent être d'un modèle connu qui est rappelé dans [Fig. 2a]. A titre d'exemple, le photodétecteur 21 qui est montré dans cette figure est une photodiode sensible au rayonnement R₁, et polarisée par la tension V_{BIAS}. Cette photodiode fait partie du circuit de détection infrarouge 20. La cellule de lecture 11 associée, qui fait partie du circuit de lecture 10, comprend les composants électroniques suivants :
- un condensateur d'intégration C_{INT} qui est connecté pour recevoir, à travers l'élément de connexion 30, les charges photoélectriques générées dans le photodétecteur 21 par le rayonnement R₁ ;
- un transistor T1, dit transistor d'injection, qui permet d'autoriser ou de bloquer par une tension de polarisation V_{POL}, le transfert des charges photoélectriques du photodétecteur 21 au condensateur d'intégration C_{INT} ;
- un transistor T2, dit transistor anti-éblouissement, qui permet d'autoriser ou de bloquer par une tension de de commande V_{AB}, une évacuation de charges photoélectriques excessives qui pourraient être présentes au niveau du photodétecteur 21 et du condensateur d'intégration C_{INT} ;
- un transistor T3, dit transistor de sélection de pixel, qui permet de sélectionner par une tension de commande Φ_{SEL}, le photodétecteur 21 parmi tous ceux d'une même ligne à l'intérieur de l'agencement matriciel du circuit de détection infrarouge 20 ;
- un transistor T4, dit transistor de réinitialisation («reset» en anglais), qui permet d'évacuer par une tension de commande Φ_{R}, les charges photoélectriques présentes dans le condensateur d'intégration C_{INT} après chaque cycle de lecture ;
- un transistor T5, à fonction de transistor suiveur, qui reçoit sur sa grille les charges photoélectriques en provenance du condensateur d'intégration C_{INT} à chaque cycle de lecture, et qui est polarisé par une tension V_{AA} ; et
- un transistor T6, dit transistor de sélection de ligne, qui permet de sélectionner par une tension de commande Φ_{ROW}, la ligne du photodétecteur 21 parmi toutes celles de l'agencement matriciel du circuit de détection infrarouge 20, et qui transmet un signal de lecture à un bus de transmission 13.
Le fonctionnement d'une telle cellule de lecture 11 est supposé connu, si bien qu'il n'est pas répété ici. On indique seulement que le transistor d'injection T1 est mis dans un état bloqué ou dans un état passant en commandant de façon appropriée les valeurs des tensions V_{POL}, V_{BIAS} et V_{AB}. Lorsque le transistor d'injection T1 est mis ainsi dans l'état bloqué, un fonctionnement du photodétecteur 21 est inhibé, ce qui peut être nécessaire pour éviter une dégradation de ce photodétecteur 21 lorsqu'il est susceptible de recevoir du rayonnement alors qu'il n'est pas à basse température.

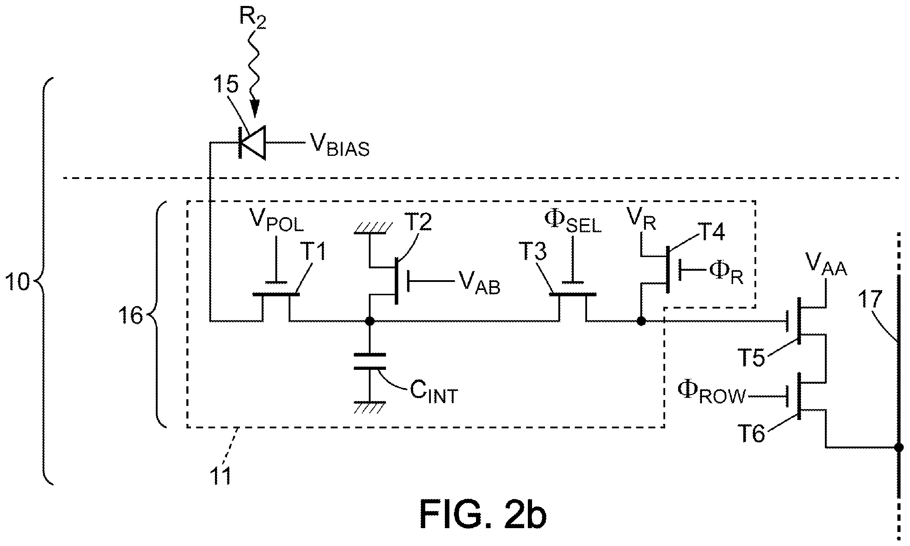

[Fig. 2b] correspond à [Fig. 2a] pour chaque ensemble de photodétection qui est ajouté par l'invention au circuit de lecture 10. A titre d'exemple, le photodétecteur supplémentaire 15 qui est représenté est constitué par une photodiode sensible au rayonnement R₂, et la cellule de lecture 16 est intermédiaire entre le photodétecteur supplémentaire 15 qui lui correspond et un bus de transmission 17. Chaque cellule de lecture 16 peut avoir une constitution qui est identique à celle qui vient d'être décrite pour les cellules de lecture 11 en référence à [Fig. 2a]. Mais cette fois-ci, les photodétecteurs supplémentaires 15 et leurs cellules de lecture 16 font ensemble partie du circuit de lecture 10, de sorte que chaque photodétecteur supplémentaire 15 est connecté électriquement à la cellule de lecture 16 correspondante d'une façon qui est interne au circuit intégré de lecture 10.

Le premier mode de fonctionnement du circuit de lecture 10, qui utilise les photodétecteurs 21 sensibles au rayonnement infrarouge R₁ et les cellules de lecture 11, peut être un mode de fonctionnement de mission. A cause des photodétecteurs 21, l'ensemble du capteur hybride 1 doit être porté à basse température et basse pression pour ce premier mode de fonctionnement. Pour cela, le capteur hybride 1 est contenu dans un cryostat (non représenté) et reçoit le rayonnement R₁ à travers un hublot (non représenté) qui est transparent à ce rayonnement R₁.

Par exemple, le capteur hybride 1 peut être destiné à une mission d'imagerie spatiale infrarouge à bord d'un satellite. Dans ce but, il doit être intégré à un instrument optique qui comprend un système imageur, tel qu'un télescope par exemple. Plus précisément, le capteur hybride 1 est intégré dans un assemblage de plan focal du système imageur, cet assemblage de plan focal pouvant éventuellement comprendre d'autres capteurs et étant combiné avec le cryostat. Il est alors nécessaire d'ajuster la position du capteur hybride 1 par rapport au système imageur, à l'intérieur de l'instrument optique, d'une part transversalement par rapport à l'axe optique du système imageur, et d'autre part parallèlement à cet axe optique pour mettre les photodétecteurs 21 dans le plan focal du système imageur. Cette intégration en position du capteur hybride 1 dans l'instrument optique, appelée alignement optique du capteur hybride 1, peut être effectuée en mettant en œuvre le second mode de fonctionnement du circuit de lecture 10, qui utilise les photodétecteurs supplémentaires 15 sans utiliser les photodétecteurs 21 du circuit de détection infrarouge 20. L'intégration en position du capteur hybride 1 dans l'instrument optique peut ainsi ne pas nécessiter de mettre le capteur hybride 1 à basse température et/ou basse pression, puisque les photodétecteurs 21 ne sont pas utilisés pour cette intégration.

Lorsque cette intégration est effectuée avec le capteur hybride 1 complet, c'est-à-dire constitué par le circuit de lecture 10 et le circuit de détection infrarouge 20 assemblés l'un à l'autre, il peut être nécessaire d'empêcher les photodétecteurs 21 de fonctionner s'ils sont exposés à du rayonnement, notamment à température ambiante, lorsque les conditions environnementales pour lesquelles ces photodétecteurs 21 sont conçus ne sont pas reproduites. Une telle inhibition des photodétecteurs 21 peut être produite électriquement en mettant les transistors d'injection T1 des cellules de lecture 11 dans l'état bloqué, comme indiqué plus haut.

Il est aussi possible d'effectuer cette intégration comme une étape préparatoire à une intégration définitive, auquel cas elle peut être effectuée alors que le circuit de détection infrarouge 20 n'a pas encore été assemblé avec le circuit de lecture 10. Dans ce cas, l'étape préparatoire d'intégration peut être effectuée avec le circuit de lecture 10 qui est introduit dans l'instrument optique alors qu'il est encore dépourvu du circuit de détection infrarouge 20.

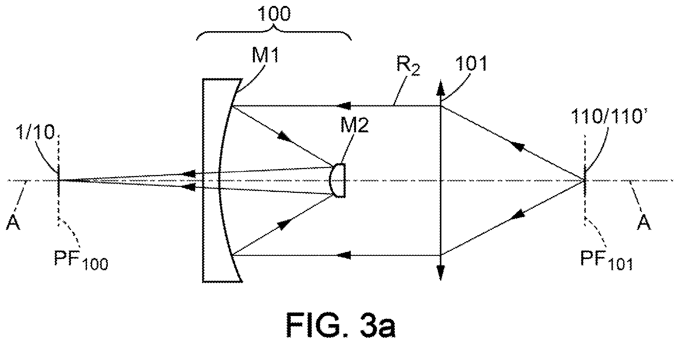

[Fig. 3a] illustre le principe d'une telle intégration en position du capteur hybride 1. Le système imageur est un télescope à deux miroirs, à titre d'exemple non-limitatif, désigné par la référence 100. M1 désigne le miroir primaire de ce télescope 100, M2 son miroir secondaire, et PF₁₀₀ son plan focal image. Pour effectuer l'intégration du capteur hybride 1 avec le télescope 100, un collimateur 101 est assemblé temporairement mais rigidement avec le télescope 100, devant l'entrée optique de ce dernier. Pour raison de simplicité de la figure, le collimateur 101 est symbolisé par une lentille convergente. Alors, une source lumineuse qui est placée au foyer objet du collimateur 101 est imagée au foyer image du télescope 100, c'est-à-dire à l'intersection de son axe optique A-A avec son plan focal image PF₁₀₀. PF₁₀₁ désigne le plan focal objet du collimateur 101.

Pour réaliser l'ajustement transversal de la position du capteur hybride 1, une mire 110 qui est éclairée avec de la lumière visible, correspondant au rayonnement R₂, est placée dans le plan focal objet PF₁₀₁ du collimateur 101, par exemple à son foyer objet. Alors, le circuit de lecture 10 est déplacé perpendiculairement à l'axe optique A-A du télescope 100, en aval du miroir secondaire M2 par rapport au sens de propagation de la lumière qui entre dans le télescope 100 pour former une image dans son plan focal image PF₁₀₀, afin d'amener l'un au moins des ensembles de photodétection qui sont constitués à partir des photodétecteurs supplémentaires 15 du circuit de lecture 10, à une position voulue par rapport à l'image de la mire 110 qui est formée par la combinaison du collimateur 101 avec le télescope 100. Pendant cet ajustement transversal, la position du circuit de lecture 10 par rapport à l'image de la mire 110 est fournie en temps réel dans les images qui sont transmises successivement par les cellules de lecture 16. La position du circuit de lecture 10 par rapport au télescope 100, dans un plan qui est perpendiculaire à l'axe optique A-A, est alors fixée rigidement ou repérée lorsque l'image de la mire apparaît à la position voulue par rapport aux photodétecteurs supplémentaires 15. Eventuellement, le circuit de lecture 10 peut ensuite être décalé perpendiculairement à l'axe optique A-A conformément à la distance de séparation qui existe entre le centre de la disposition matricielle des photodétecteurs supplémentaires 15 et celui de la disposition matricielle des photodétecteurs 21 parallèlement à la surface supérieure SS₁₀ du circuit de lecture 10, afin de recentrer le champ optique d'entrée du télescope 100 par rapport aux photodétecteurs 21.

Pour réaliser l'ajustement longitudinal de la position du capteur hybride 1, la mire 110 est remplacée par un motif de contraste 110' qui est éclairé avec de la lumière visible, correspondant encore au rayonnement R₂, et qui est placé dans le plan focal objet PF₁₀₁ du collimateur 101. Un tel motif de contraste 110' peut être constitué par une alternance périodique de traits sombres et clairs. Eventuellement, le motif de contraste 110' peut être formé par un modulateur spatial de lumière, permettant de varier la période spatiale des traits. Alors, le circuit de lecture 10 est déplacé le long de l'axe optique A-A du télescope 100, à partir de sa position telle que fixée ou repérée précédemment à l'issue de l'ajustement longitudinal, pour augmenter un contraste du motif 110' tel qu'il apparaît dans l'image qui est formée par la combinaison du collimateur 101 avec le télescope 100, et qui est transmise en temps réel par les cellules de lecture 16. Un contraste d'image qui est maximal est obtenu lorsque les photodétecteurs supplémentaires 15 sont dans le plan focal image PF₁₀₀ du télescope 100. La position du circuit de lecture 10 par rapport au télescope 100, à l'endroit le long de l'axe optique A-A qui fournit ce maximum de contraste d'image, est fixée rigidement ou repérée. Eventuellement, le circuit de lecture 10 peut ensuite être reculé le long de l'axe optique A-A de la distance de séparation qui existe entre la surface supérieure SS₁₀ de ce circuit de lecture 10 où se trouvent les photodétecteurs supplémentaires 15, et la surface effective dans laquelle se trouvent les photodétecteurs 21 du circuit de détection infrarouge 20. Les images qui seront formées en mission par le télescope 100 avec le rayonnement infrarouge R₁, et qui seront détectées par le circuit de détection infrarouge 20 pour le premier mode de fonctionnement du circuit de lecture 10, seront alors nettes.

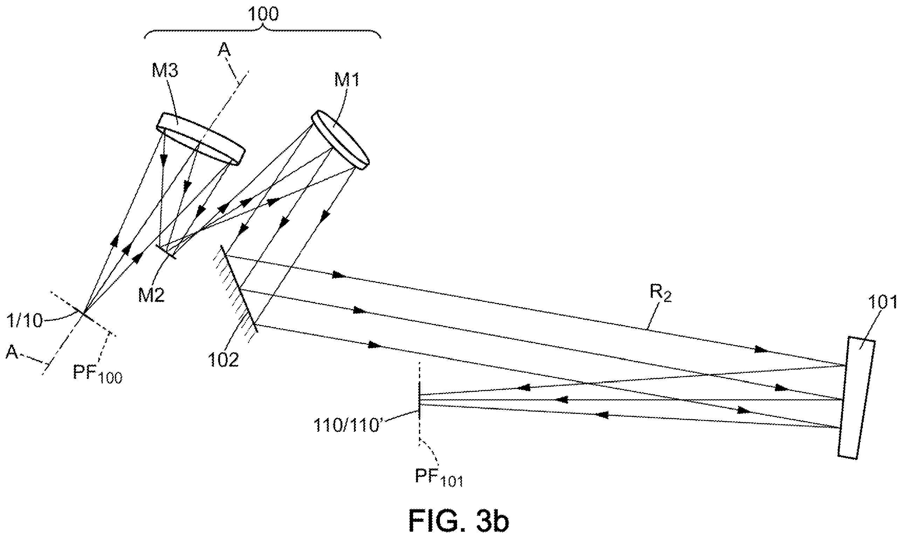

L'instrument optique qui est montré dans [Fig. 3b] comprend un télescope 100 à trois miroirs : le miroir primaire M1, le miroir secondaire M2 et le miroir tertiaire M3. Il comprend en outre un miroir escamotable 102 et un miroir parabolique formant collimateur. Par simplicité, le miroir parabolique formant collimateur est désigné aussi par la référence 101. En fait, le miroir escamotable 102 et le miroir parabolique 101 peuvent faire partie d'une voie de calibration de l'instrument optique. En configuration de mission de cet instrument optique, le miroir escamotable 102 est écarté de sorte que le télescope 100 possède un champ optique d'entrée qui est libre en amont du miroir primaire M1, par rapport au sens de propagation du rayonnement qui entre dans le télescope 100 pour former une image dans son plan focal image PF₁₀₀. En configuration de calibration de l'instrument optique, le miroir escamotable 102 est placé dans le champ optique d'entrée du télescope 100, en amont du miroir primaire M1, pour que le rayonnement visible R₂ qui provient du plan focal objet PF₁₀₁ du miroir parabolique 101 et qui est réfléchi par ce dernier puis par le miroir 102 pénètre dans le télescope 100. Les ajustements transversal et longitudinal de la position du circuit de lecture 10 par rapport au télescope 100 peuvent alors être réalisés comme décrit précédemment en référence à [Fig. 3a], en utilisant la configuration de calibration, en plaçant successivement la mire 110 et le motif de contraste 110' dans le plan focal objet PF₁₀₁ du miroir parabolique 101, et en éclairant cette mire 110 et ce motif de contraste 110' avec le rayonnement visible R₂.

Evidemment, l'instrument optique comprend en outre une chaîne de traitement des signaux électriques de lecture d'images qui sont produits par les cellules de lecture 11. En remplaçant les signaux de lecture d'images qui sont destinés à être produits par les cellules de lecture 11 dans le premier mode de fonctionnement du circuit de lecture 10, par ceux qui sont produits par les cellules de lecture 16 dans le second mode de fonctionnement, en entrée de la chaîne de traitement des signaux de lecture d'images, il est possible de tester le fonctionnement de cette chaîne de traitement des signaux en n'utilisant que le second mode de fonctionnement du circuit de lecture 10. Pour cela, le circuit de lecture 10 peut comprendre un commutateur commandé qui transmet à une sortie de ce circuit de lecture 10 destinée à être connectée à une entrée de la chaîne de traitement, soit les signaux de lecture d'images provenant des cellules de lecture 11 pour le premier mode de fonctionnement, soit les signaux de lecture d'images provenant des cellules de lecture 16 pour le second mode de fonctionnement. Le test du fonctionnement de la chaîne de traitement des signaux de lecture peut ainsi être effectué en utilisant les photodétecteurs supplémentaires 15 et le collimateur ou miroir parabolique 101, sans utiliser les photodétecteurs 21. Grâce à cela, il n'est pas nécessaire d'amener à basse température et/ou basse pression l'ensemble du capteur hybride 1 pour effectuer ce test de fonctionnement de la chaîne de traitement des signaux électriques de lecture d'images. Ce test peut même être effectué alors que le circuit de détection infrarouge 20 n'a pas encore été assemblé avec le circuit de lecture 10. Il est possible de tester de la même façon et au moins partiellement la compatibilité électromagnétique de la chaîne de traitement des signaux électriques de lecture d'images.

## Revendications

1. Circuit de lecture (10) intégré à substrat de silicium, adapté pour être connecté à un circuit intégré de photodétecteurs (21) sensibles dans un domaine spectral infrarouge, qui est externe au circuit de lecture et appelé circuit de détection infrarouge (20), avec des substrats semiconducteurs respectifs dudit circuit de lecture et dudit circuit de détection infrarouge qui sont différents, un substrat à faible largeur de bande interdite pour constituer le circuit de détection infrarouge et un substrat de silicium pour constituer le circuit de lecture, afin de former un capteur hybride (1), ledit circuit de lecture comprenant :
- des cellules de lecture (11, 16) qui sont séparées les unes des autres à l'intérieur du circuit de lecture (10) ; et
- des zones de contacts électriques (12) qui sont dédiées respectivement à certaines au moins des cellules de lecture (11), et adaptées pour transférer auxdites certaines au moins des cellules de lecture, dans un premier mode de fonctionnement du circuit de lecture (10) pour lequel ledit circuit de lecture est connecté au circuit de détection infrarouge (20), des charges photoélectriques qui ont été générées dans les photodétecteurs (21) du circuit de détection infrarouge, le circuit de lecture (10) étant **caractérisé en ce qu'**il comprend en outre :
- des photodétecteurs supplémentaires (15) qui sont intégrés audit circuit de lecture (10), et qui sont distincts des photodétecteurs (21) du circuit de détection infrarouge (20), et **en ce que** le circuit de lecture (10) est agencé pour, dans un second mode de fonctionnement dudit circuit de lecture, transférer à certaines des cellules de lecture (11, 16), d'une façon interne audit circuit de lecture, d'autres charges photoélectriques qui ont été générées dans les photodétecteurs supplémentaires (15).

2. Circuit de lecture (10) selon la revendication 1, agencé de sorte qu'une partie des cellules de lecture (11) dudit circuit de lecture soient connectées électriquement aux zones de contacts électriques (12) sans être connectées électriquement à des sorties des photodétecteurs supplémentaires (15) dudit circuit de lecture, et qu'une partie supplémentaire des cellules de lecture (16) dudit circuit de lecture soient connectées électriquement aux sorties des photodétecteurs supplémentaires sans être connectées électriquement aux zones de contacts électriques.

3. Circuit de lecture (10) selon la revendication 1 ou 2, adapté en outre pour empêcher que des charges photoélectriques soient générées dans les photodétecteurs (21) du circuit de détection infrarouge (20), ou pour empêcher que des charges photoélectriques qui sont générées dans les photodétecteurs du circuit de détection infrarouge soient transférées à des cellules de lecture (11) du circuit de lecture, dans le second mode de fonctionnement dudit circuit de lecture et si ledit circuit de lecture est connecté audit circuit de détection infrarouge.

4. Circuit de lecture (10) selon l'une quelconque des revendications précédentes, dans lequel les photodétecteurs supplémentaires (15) dudit circuit de lecture sont de technologie CMOS à base de silicium.

5. Circuit de lecture (10) selon l'une quelconque des revendications précédentes, dans lequel chaque photodétecteur supplémentaire (15) dudit circuit de lecture est une photodiode réalisée dans ou sur le substrat de silicium dudit circuit de lecture, une capacité Metal-Oxyde-Silicium ou Polysilicium-Oxyde-Silicium réalisée sur le substrat de silicium dudit circuit de lecture, ou un phototransistor réalisé dans ou sur le substrat de silicium dudit circuit de lecture.

6. Circuit de lecture (10) selon l'une quelconque des revendications précédentes, dans lequel chaque photodétecteur supplémentaire (15) dudit circuit de lecture est sensible dans un intervalle spectral compris entre 0,4 µm et 1,1 µm.

7. Circuit de lecture (10) selon l'une quelconque des revendications précédentes, dans lequel les photodétecteurs supplémentaires (15) du circuit de lecture sont situés sur un même côté dudit circuit de lecture que les zones de contacts électriques (12) destinées à connecter le circuit de détection infrarouge (20) audit circuit de lecture.

8. Circuit de lecture (10) selon l'une quelconque des revendications précédentes, dans lequel les photodétecteurs supplémentaires (15) du circuit de lecture sont répartis sur une face dudit circuit de lecture selon au moins une disposition matricielle, en étant situés à des intersections de colonnes et de lignes de ladite disposition matricielle.

9. Circuit de lecture (10) selon l'une quelconque des revendications précédentes, dans lequel les zones de contacts électriques (12) dudit circuit de lecture sont réparties selon une autre disposition matricielle, en étant situés à des intersections de colonnes et de lignes de ladite autre disposition matricielle.

10. Capteur hybride (1) comprenant :
- le circuit de lecture (10) selon l'une quelconque des revendications précédentes ;
- le circuit de détection infrarouge (20), qui comprend les photodétecteurs (21) sensibles dans le domaine spectral infrarouge, et qui est connecté au circuit de lecture (10) ;
et
- des éléments de connexions électriques (30) qui relient une-à-une les zones de contacts électriques (12) du circuit de lecture (10) à des zones de contacts électriques du circuit de détection infrarouge (20), de façon à transférer pendant une utilisation du capteur hybride (1) conforme au premier mode de fonctionnement dudit circuit de lecture, les charges photoélectriques générées dans les photodétecteurs (21) dudit circuit de détection infrarouge aux cellules de lecture (11) correspondantes dudit circuit de lecture.

11. Procédé d'intégration d'un capteur hybride (1) dans un instrument optique qui comprend un système imageur (100), le système imageur étant destiné à former une image sur un circuit de détection infrarouge (20) du capteur hybride pendant une utilisation de l'instrument optique, le procédé étant **caractérisé en ce que** :
- le capteur hybride (1) est conforme à la revendication 10, et le circuit de lecture (10) dudit capteur hybride est conforme à la revendication 8 ; et
- le procédé comprend au moins une étape d'alignement optique lors de laquelle une position du circuit de lecture (10) par rapport au système imageur (100) est mesurée ou ajustée en utilisant les photodétecteurs supplémentaires (15) dudit circuit de lecture.

12. Procédé selon la revendication 11, suivant lequel l'étape d'alignement optique comprend d'ajuster la position du circuit de lecture (10) perpendiculairement à un axe optique (A-A) du système imageur (100), en utilisant une mire (110) qui est positionnée fixement par rapport au système imageur de sorte que ledit système imageur forme une image de la mire sur les photodétecteurs supplémentaires (15) du circuit de lecture, puis le second mode de fonctionnement du circuit de lecture est activé pour saisir l'image formée sur les photodétecteurs supplémentaires, et la position du circuit de lecture est ajustée perpendiculairement à l'axe optique du système imageur pour réduire un décalage entre l'image saisie et lesdits photodétecteurs supplémentaires.

13. Procédé selon la revendication 11, suivant lequel l'étape d'alignement optique comprend d'ajuster la position du circuit de lecture (10) le long d'un axe optique (A-A) du système imageur (100), en utilisant un motif de contraste (110') qui est positionné fixement par rapport au système imageur de sorte que ledit système imageur forme une image du motif de contraste sur les photodétecteurs supplémentaires (15) du circuit de lecture, puis le second mode de fonctionnement du circuit de lecture est activé pour saisir l'image formée sur les photodétecteurs supplémentaires, et la position du circuit de lecture est ajustée le long de l'axe optique du système imageur pour maximiser un contraste de l'image saisie.

14. Procédé selon la revendication 12 ou 13 suivant lequel, pour l'étape d'alignement optique, la mire (110) ou le motif de contraste (110'), respectivement, est combiné(e) rigidement avec un collimateur (101) de sorte que ladite mire ou ledit motif de contraste soit situé(e) dans un plan focal objet (PF₁₀₁) du collimateur, puis le système imageur (100) de l'instrument optique forme l'image qui est saisie par les photodétecteurs supplémentaires (15) à partir de rayons lumineux transmis par le collimateur.

15. Procédé selon l'une quelconque des revendications 11 à 14, comprenant en outre une étape de test électrique ou électromagnétique, lors de laquelle un fonctionnement d'une chaîne de traitement de signaux électriques qui est connectée en aval du circuit de lecture (10), est testée en mettant en œuvre le second mode de fonctionnement dudit circuit de lecture.

## Patentansprüche

1. Integrierte Ausleseschaltung (10) auf Silizium-Substrat, die geeignet ist, mit einer integrierten Schaltung, genannt Infrarot-Detektionsschaltung (20), verbunden zu werden, die in einem infraroten Spektralbereich empfindliche Fotodetektoren (21) aufweist und extern zur Ausleseschaltung ist, mit jeweiligen Halbleitersubstraten der Ausleseschaltung und der Infrarot-Detektionsschaltung, die unterschiedlich sind, ein Substrat mit einer kleiner Bandlücke für die Infrarot-Detektionsschaltung und ein Silizium-Substrat für die Ausleseschaltung, um einen Hybrid-Sensor (1) zu bilden, wobei die Ausleseschaltung aufweist:
- voneinander getrennte Auslesezellen (11, 16) im Innern der Ausleseschaltung (100); und
- elektrische Kontaktzonen (12), die jeweils mindestens einigen der Auslesezellen (11) zugeordnet sind und geeignet sind, in einem ersten Betriebsmodus der Ausleseschaltung (10), in welchem die Ausleseschaltung mit der Infrarot-Schaltung (20) verbunden ist, fotoelektrische Ladungen, die in den Fotodetektoren (21) der Infrarot-Detektionsschaltung erzeugt worden sind, zu den mindestens einigen der Auslesezellen zu transferieren,
wobei die Ausleseschaltung (10) **dadurch gekennzeichnet ist, dass** sie ferner aufweist:
- zusätzliche Fotodetektoren (15), die in die Ausleseschaltung (10) integriert sind und die sich von den Fotodetektoren (21) der Infrarot-Detektionsschaltung (20) unterscheiden,
und dadurch, dass die Ausleseschaltung (10) eingerichtet ist, um in einem zweiten Betriebsmodus der Ausleseschaltung andere fotoelektrische Ladungen, die in den zusätzlichen Fotodetektoren (15) erzeugt worden sind, auf interne Weise zu einigen der Auslesezellen (11, 16) zu transferieren.

2. Ausleseschaltung (10) nach Anspruch 1, die derart eingerichtet ist, dass ein Teil der Auslesezellen (11) der Ausleseschaltung mit den Kontaktzonen (12) elektrisch verbunden ist, ohne mit Ausgängen der zusätzlichen Fotodetektoren (15) der Ausleseschaltung elektrisch verbunden zu sein, und dass ein zusätzlicher Teil der Auslesezellen (16) der Ausleseschaltung mit den Ausgängen der zusätzlichen Fotodetektoren elektrisch verbunden ist, ohne mit den elektrischen Kontaktzonen elektrisch verbunden zu sein.

3. Ausleseschaltung (10) nach Anspruch 1 oder 2, die ferner angepasst ist, um zu verhindern, dass fotoelektrische Ladungen in den Fotodetektoren (21) der Infrarot-Detektionsschaltung (20) erzeugt werden, oder um zu verhindern, dass fotoelektrische Ladungen, die in den Fotodetektoren der Infrarot-Detektionsschaltung erzeugt worden sind, zu Auslesezellen (11) der Ausleseschaltung, in dem zweiten Betriebsmodus der Ausleseschaltung und wenn die Ausleseschaltung mit der Infrarot-Detektionsschaltung verbunden ist, transferiert werden.

4. Ausleseschaltung (10) nach einem der vorstehenden Ansprüche, in welcher die zusätzlichen Fotodetektoren (15) der Ausleseschaltung vom Typ CMOS-Technologie auf Siliziumbasis sind.

5. Ausleseschaltung (10) nach einem der vorstehenden Ansprüche, in welcher jeder zusätzliche Fotodetektor (15) der Ausleseschaltung eine in oder auf dem Siliziumsubstrat der Ausleseschaltung realisierte Fotodiode, eine auf dem Siliziumsubstrat der Ausleseschaltung realisierte Metall-Oxid-Silizium-Kapazität oder Polysilizium-Oxid-Silizium-Kapazität oder ein in oder auf dem Siliziumsubstrat der Ausleseschaltung realisierter Fototransistor ist.

6. Ausleseschaltung (10) nach einem der vorstehenden Ansprüche, in welcher jeder zusätzliche Fotodetektor (15) der Ausleseschaltung in einem Spektralintervall zwischen 0,4µm und 1,1µm empfindlich ist.

7. Ausleseschaltung (10) nach einem der vorstehenden Ansprüche, in welcher die zusätzlichen Fotodetektoren (15) der Ausleseschaltung auf der gleichen Seite der Ausleseschaltung angeordnet sind wie die elektrischen Kontaktzonen (12), die vorgesehen sind, die Infrarot-Detektionsschaltung (20) mit der Ausleseschaltung zu verbinden.

8. Ausleseschaltung (10) nach einem der vorstehenden Ansprüche, in welcher die zusätzlichen Fotodetektoren (15) der Ausleseschaltung auf einer Fläche der Ausleseschaltung gemäß mindestens einer Matrixanordnung verteilt sind, indem sie an Schnittpunkten von Spalten und Zeilen der Matrixanordnung angeordnet sind.

9. Ausleseschaltung (10) nach einem der vorstehenden Ansprüche, in welcher die elektrischen Kontaktzonen (12) der Ausleseschaltung gemäß einer anderen Matrixanordnung verteilt sind, indem sie an Schnittpunkten von Spalten und Zeilen der anderen Matrixanordnung angeordnet sind.

10. Hybridsensor (1) aufweisend:
- die Ausleseschaltung (10) nach einem der vorstehenden Ansprüche;
- die Infrarot-Detektionsschaltung (20), die die in dem infraroten Spektralbereich empfindlichen Fotodetektoren (21) aufweist und die mit der Ausleseschaltung (10) verbunden ist; und
- elektrische Verbindungselemente (30), die die elektrischen Kontaktzonen (12) der Ausleseschaltung (10) eins-zu-eins mit elektrischen Kontaktzonen der Infrarot-Detektionsschaltung (20) verbinden, um so während einer Verwendung des Hybridsensors (1), die einem ersten Betriebsmodus der Ausleseschaltung entspricht, die in den Fotodetektoren (21) der Infrarot-Detektionsschaltung erzeugten fotoelektrischen Ladungen zu den entsprechenden Auslesezellen (11) der Ausleseschaltung zu transferieren.

11. Verfahren zum Integrieren eines Hybridsensors (1) in ein optisches Instrument, das ein Abbildungssystem (100) aufweist, wobei das Abbildungssystem vorgesehen ist, während einer Verwendung des optischen Instruments ein Bild an einer Infrarot-Detektionsschaltung (20) des Hybridsensors zu erzeugen, wobei das Verfahren **dadurch gekennzeichnet ist, dass**
- der Hybridsensor (1) dem Anspruch 10 entspricht und die Ausleseschaltung (10) des Hybridsensors dem Anspruch 8 entspricht; und
- das Verfahren mindestens einen optischen Ausrichtungsschritt aufweist, in welchem eine Position der Ausleseschaltung (10) bezüglich des Abbildungssystems (100) unter Verwendung der zusätzlichen Fotodetektoren (15) der Ausleseschaltung gemessen oder angepasst wird.

12. Verfahren nach Anspruch 11, gemäß welchem der optische Ausrichtungsschritt aufweist: Anpassen der Position der Ausleseschaltung (10) senkrecht zu einer optischen Achse (A-A) des Abbildungssystems (100) unter Verwendung eines Visierkorns (110), das fest bezüglich des Abbildungssystems positioniert ist, so dass das Abbildungssystem ein Bild des Visierkorns an den zusätzlichen Fotodetektoren (15) der Ausleseschaltung erzeugt, wonach der zweite Betriebsmodus der Ausleseschaltung aktiviert wird, um das an den zusätzlichen Fotodetektoren erzeugte Bild zu erfassen, und die Position der Ausleseschaltung senkrecht zu der optischen Achse des Abbildungssystems angepasst wird, um einen Versatz zwischen dem erfassten Bild und den zusätzlichen Fotodetektoren zu reduzieren.

13. Verfahren nach Anspruch 11, gemäß welchem der optische Ausrichtungsschritt aufweist: Anpassen der Position der Ausleseschaltung (10) entlang einer optischen Achse (A-A) des Abbildungssystems (100) unter Verwendung eines Kontrastmotivs (110'), das fest bezüglich des Abbildungssystems angeordnet ist, so dass das Abbildungssystem ein Bild des Kontrastmotivs an den zusätzlichen Fotodetektoren (15) der Ausleseschaltung erzeugt, wonach der zweite Betriebsmodus der Ausleseschaltung aktiviert wird, um das an den zusätzlichen Fotodetektoren erzeugte Bild zu erfassen, und die Position der Ausleseschaltung entlang der optischen Achse des Abbildungssystems angepasst wird, um einen Kontrast des erfassten Bilds zu maximieren.

14. Verfahren nach Anspruch 12 oder 13, gemäß welchem für den optischen Ausrichtungsschritt jeweils das Visierkorn (110) oder das Kontrastmotiv (110') starr mit einem Kollimator (101) kombiniert wird, so dass das Visierkorn oder das Kontrastmotiv in einer fokalen Objektebene (PF₁₀₁) des Kollimators angeordnet ist, dann das Abbildungssystem (100) des optischen Instruments mit von dem Kollimator übertragenen Lichtstrahlen das Bild erzeugt, das von den zusätzlichen Fotodetektoren (15) erfasst wird.

15. Verfahren nach einem der Ansprüche 11 bis 14, aufweisend ferner einen Schritt eines elektrischen oder elektromagnetischen Tests, in welchem ein Betrieb einer Verarbeitungskette, die elektrische Signale verarbeitet und nach der Ausleseschaltung angeschlossen ist, getestet wird, indem der zweite Betriebsmodus der Ausleseschaltung ausgeführt wird.

## Claims

1. A readout circuit (10) integrated in a silicon substrate, designed to be connected to an integrated circuit of photodetectors (21) that are sensitive in an infrared spectral range, which is external to the readout circuit and called infrared detection circuit (20), with respective semiconductor substrates of said readout circuit and of said infrared detection circuit which are different, a substrate with a low band gap to constitute the infrared detection circuit and a silicon substrate to constitute the readout circuit, in order to form a hybrid sensor (1), said readout circuit comprising:
- readout cells (11, 16) that are separated from each other within the readout circuit (10);
and
- electrical contact areas (12) which are respectively dedicated to at least some of the readout cells (11), and designed to transfer to said at least some of the readout cells, in a first operating mode of the readout circuit (10) for which said readout circuit is connected to the infrared detection circuit (20), photoelectric charges which have been generated in the photodetectors (21) of the infrared detection circuit,
the readout circuit (10) being **characterised in that** it further comprises:
- additional photodetectors (15) which are integrated into said readout circuit (10), and which are distinct from the photodetectors (21) of the infrared detection circuit (20),
and **in that** the readout circuit (10) is arranged, in a second operating mode of said readout circuit, to transfer to some of the readout cells (11, 16), internally to said readout circuit, other photoelectric charges that have been generated in the additional photodetectors (15).

2. The readout circuit (10) according to Claim 1, arranged such that part of the readout cells (11) of said readout circuit are electrically connected to the electrical contact areas (12) without being electrically connected to outputs of the additional photodetectors (15) of said readout circuit, and an additional part of the readout cells (16) of said readout circuit are electrically connected to the outputs of the additional photodetectors without being electrically connected to the electrical contact areas.

3. The readout circuit (10) according to Claim 1 or 2, further designed to prevent photoelectric charges from being generated in the photodetectors (21) of the infrared detection circuit (20), or to prevent photoelectric charges that are generated in the photodetectors of the infrared detection circuit from being transferred to readout cells (11) of the readout circuit, in the second operating mode of said readout circuit and if said readout circuit is connected to said infrared detection circuit.

4. The readout circuit (10) according to any one of the preceding claims, wherein the additional photodetectors (15) of said readout circuit are of silicon-based CMOS technology.

5. The readout circuit (10) according to any one of the preceding claims, wherein each additional photodetector (15) of said readout circuit is a photodiode made in or on the silicon substrate of said readout circuit, a metal-oxide-silicon or polysilicon-oxide-silicon capacitor made on the silicon substrate of said readout circuit, or a phototransistor made in or on the silicon substrate of said readout circuit.

6. The readout circuit (10) according to any one of the preceding claims, wherein each additional photodetector (15) of said readout circuit is sensitive in a spectral range comprised between 0.4 µm and 1.1 µm.

7. The readout circuit (10) according to any one of the preceding claims, wherein the additional photodetectors (15) of the readout circuit are located on a same side of said readout circuit as the electrical contact areas (12) intended to connect the infrared detection circuit (20) to said readout circuit.

8. The readout circuit (10) according to any one of the preceding claims, wherein the additional photodetectors (15) of the readout circuit are distributed on a face of said readout circuit according to at least one matrix arrangement, being located at intersections of columns and rows of said matrix arrangement.

9. The readout circuit (10) according to any one of the preceding claims, wherein the electrical contact areas (12) of said readout circuit are distributed according to another matrix arrangement, being located at intersections of columns and rows of said another matrix arrangement.

10. A hybrid sensor (1) comprising:
- the readout circuit (10) according to any one of the preceding claims;
- the infrared detection circuit (20), which comprises the photodetectors (21) that are sensitive in the infrared spectral range, and which is connected to the readout circuit (10); and
- electrical connection elements (30) that connect one-to-one the electrical contact areas (12) of the readout circuit (10) to electrical contact areas of the infrared detection circuit (20), so as to transfer during a use of the hybrid sensor (1) in accordance with the first operating mode of said readout circuit, the photoelectric charges generated in the photodetectors (21) of said infrared detection circuit to the corresponding readout cells (11) of said readout circuit.

11. A method for integrating a hybrid sensor (1) into an optical instrument which comprises an imaging system (100), the imaging system being intended to form an image on an infrared detection circuit (20) of the hybrid sensor during a use of the optical instrument, the method being **characterised in that**:
- the hybrid sensor (1) is in accordance with Claim 10, and the readout circuit (10) of said hybrid sensor is in accordance with Claim 8; and
- the method comprises at least one optical alignment step in which a position of the readout circuit (10) relative to the imaging system (100) is measured or adjusted using the additional photodetectors (15) of said readout circuit.

12. The method according to Claim 11, wherein the optical alignment step comprises adjusting the position of the readout circuit (10) perpendicular to an optical axis (A-A) of the imaging system (100), using a target (110) that is fixedly positioned relative to the imaging system so that said imaging system forms an image of the target on the additional photodetectors (15) of the readout circuit, then the second operating mode of the readout circuit is activated to capture the image formed on the additional photodetectors, and the position of the readout circuit is adjusted perpendicular to the optical axis of the imaging system to reduce an offset between the captured image and said additional photodetectors.

13. The method according to Claim 11, wherein the optical alignment step comprises adjusting the position of the readout circuit (10) along an optical axis (A-A) of the imaging system (100), using a contrast pattern (110') that is fixedly positioned relative to the imaging system so that said imaging system forms an image of the contrast pattern on the additional photodetectors (15) of the readout circuit, then the second operating mode of the readout circuit is activated to capture the image formed on the additional photodetectors, and the position of the readout circuit is adjusted along the optical axis of the imaging system to maximise a contrast of the captured image.

14. The method according to Claim 12 or 13 wherein, for the optical alignment step, the target (110) or the contrast pattern (110'), respectively, is rigidly combined with a collimator (101) so that said target or contrast pattern is located in an object focal plane (PF₁₀₁) of the collimator, then the imaging system (100) of the optical instrument forms the image that is captured by the additional photodetectors (15) from light rays transmitted by the collimator.

15. The method according to any one of Claims 11 to 14, further comprising an electrical or electromagnetic test step, in which an operation of an electrical signal processing chain that is connected downstream of the readout circuit (10) is tested by implementing the second operating mode of said readout circuit.
